Europäisches Patentamt

European Patent Office

Office européen des brevets

(11) Veröffentlichungsnummer: **0 077 500**
**A2**

## (12) EUROPÄISCHE PATENTANMELDUNG

(21) Anmeldenummer: 82109294.7

(22) Anmeldetag: 07.10.82

(51) Int. Cl.³: **H 03 K 21/02**
**H 03 K 5/02**

(30) Priorität: 21.10.81 DE 3141790

(43) Veröffentlichungstag der Anmeldung:
27.04.83 Patentblatt 83/17

(84) Benannte Vertragsstaaten:
AT DE FR GB IT

(71) Anmelder: SIEMENS AKTIENGESELLSCHAFT
Berlin und München Wittelsbacherplatz 2
D-8000 München 2(DE)

(72) Erfinder: Kriedt, Hans
Triester Strasse 33
D-8000 München 80(DE)

(72) Erfinder: Fenk, Josef, Dipl.-Ing.
Deutenhauserstrasse 10
D-8057 Eching/Ottenburg(DE)

(54) Integrierbare Frequenzteilerschaltung.

(57) Die erfindungsgemäße Schaltung weist neben dem in einer der üblichen Weisen ausgestalteten Frequenzteiler einen durch einen Differenzverstärker bzw. einer Kaskade von Differenzverstärkern gegebenen Vorverstärker auf, der über einen Operationsverstärker gegengekoppelt ist. Dabei ist jeder der beiden Ausgänge des Differenzverstärkers bzw. der Differenzverstärkerkaskade zur Steuerung je eines Eingangs der ersten Teilerstufe des Frequenzteilers als auch - unter Vermittlung je eines Widerstands - zur Beaufschlagung je eines der beiden Eingänge des Operationsverstärkers vorgesehen, wobei die Steuerung ggf. unter Vermittlung je eines Transistors in Emitterfolgerschaltung geschehen kann.

Außerdem sind die beiden Eingänge des Operationsverstärkers über einen Kondensator miteinander verbunden, während der Ausgang des Operationsverstärkers einerseits über einen Kondensator mit dem Bezugspotential verbunden ist und andererseits am Referenzeingang des Differenzverstärkers liegt.

Die Schaltung dient dazu, um die Offsetwirkung auf den Eingang des Frequenzteilers drastisch zu reduzieren und damit die den bekannten Teilerschaltungen bei sehr hohen Eingangsfrequenzen (1 GHz) anhaftenden Frequenzschwankungen an den Ausgängen der Teilerstufen auszuschalten.

FIG 1

EP 0 077 500 A2

Croydon Printing Company Ltd

0077500

Unser Zeichen
VPA
81 P 1 1 7 1 E

Siemens Aktiengesellschaft
Berlin und München

## Integrierbare Frequenzteilerschaltung

Die Erfindung betrifft eine integrierbare Frequenzteilerschaltung, bei der das zu verarbeitende Eingangssignal über einen Vorverstärker an die zu beaufschlagenden Signaleingänge der ersten Teilerstufe des aus einer Anzahl hintereinander geschalteter gleicher Flip-Flopzellen bestehenden Frequenzteilers gelangt.

Bei hohen Frequenzen im Bereich von 1 GHz und höher ergibt sich das Problem, daß nur dann die maximale Teilerfrequenz (d.h. also die am Ausgang der ersten Teilerstufe erhaltene Frequenz) eines solchen Frequenzteilers erreichbar ist, wenn man für einen minimalen Gleichspannungsoffset an den Eingängen des Frequenzteilers sorgt. Um diesem Nachteil abzuhelfen und die Eingangsempfindlichkeit des Frequenzteilers zu verbessern, kann man einen Vorverstärker mit mehr als 20 dB Verstärkung einsetzen. Die Erfahrung zeigt jedoch, daß bei Verwendung eines normal ausgestalteten Verstärkers als Vorverstärker minimale Offsetspannungen am Verstärkereingang dann verstärkt auf den Eingang des Teilers übertragen werden. Dies führt dazu, daß die am Ausgang der ersten Teilerstufe und ggf. auch der zweiten Teilerstufe abnehmbare Frequenz erheblich (z.B. im Falle der ersten Teilerstufe bis zu mehreren hundert MHz) schwankt.

Die Aufgabe der Erfindung ist, hier eine Abhilfe zu bringen.

Um diese Aufgabe zu lösen wird gemäß der Erfindung eine Schaltung der oben angegebenen Art derart ausgestaltet, daß der als Differenzverstärker ausgebildete Vorverstärker mit seinen beiden Ausgängen zur Steuerung je eines Eingangs der ersten Teilerstufe des Frequenzteilers vorgesehen und außerdem über je einen Widerstand an je einen der beiden Eingänge eines Operationsverstärkers angeschaltet ist, und daß dabei schließlich die beiden Eingänge des Operationsverstärkers über einen Kondensator miteinander verbunden sind, während der Ausgang des Operationsverstärkers einerseits kapazitiv an das Bezugspotential gelegt und andererseits unmittelbar mit dem Referenzeingang des Differenzverstärkers verbunden ist.

Bei einer weiteren Ausgestaltung der Erfindung kann der Differenzverstärker durch eine Kaskade aus mehreren Differenzverstärkern ersetzt sein. Bei einer weiteren bevorzugten Ausgestaltung der Erfindung liegt der Referenzeingang des den Eingang der Schaltung bildenden Differenzverstärkers über einen Widerstand an einem auf Masse bezogene Referenzpotential. Dieses Referenzpotential kann zudem über einen zweiten Widerstand mit dem eigentlichen Signaleingang des Differenzverstärkers verbunden sein, was auch bei den in den beiden Figuren dargestellten Ausführungsbeispielen der Fall ist.

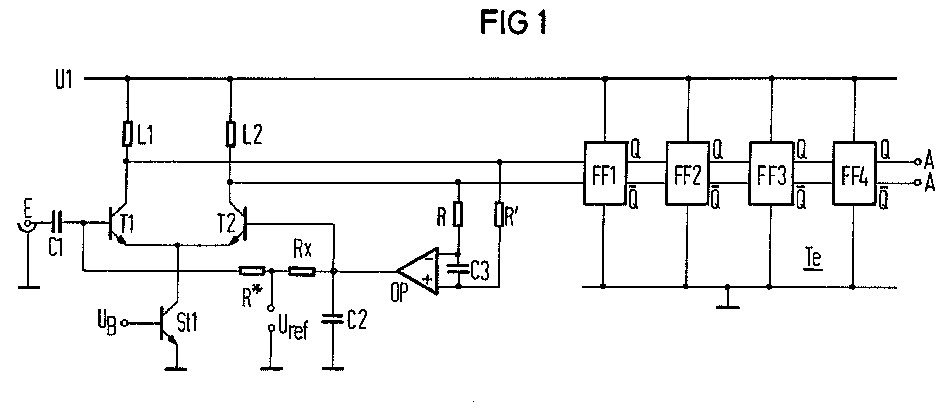

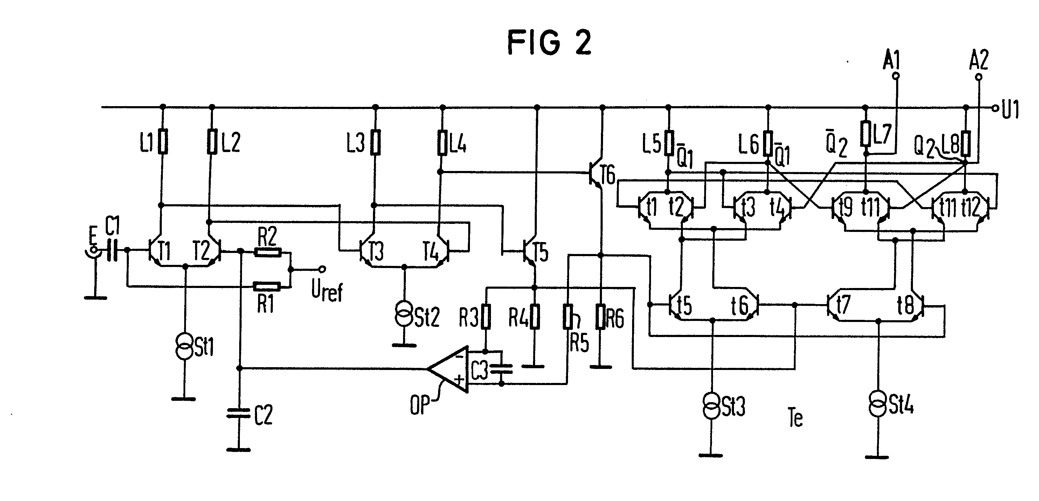

Bei der in Figur 1 dargestellten bevorzugten Ausgestaltung der Erfindung ist der Signaleingang der Frequenzteilerschaltung über einen Kondensator an den Signaleingang des ersten Differenzverstärkers und außerdem über zwei in Serie zueinander liegende Widerstände an den Referenzeingang dieses Differenzverstärkers gelegt. Falls anstelle eines einzigen Differenzverstärkers eine Kaskade aus mehreren hintereinander geschalteten Differenzverstärkern verwendet wird gilt die soeben gemachte Feststellung und die nun folgende Feststellung für den ersten Differenzverstärker der Kaskade. Die Ausgänge des Differenzverstärkers bzw. des letzten Differenzverstärkers der Kaskade dienen zur Steuerung je eines in Emitterfolgerschaltung betriebenen Transistors, wobei die Emitter dieser beiden Transistoren an je einen der beiden Eingänge des Operationsverstärker gelegt sind, während die direkte Verbindung vom Ausgang des Differenzverstärkers an die beiden Eingänge des Operationsverstärkers entfällt. Außerdem liegen die Ausgänge der beiden in Emitterfolgerschaltung betriebenen Transistoren an je einem der beiden Eingänge der ersten Teilerstufe des Frequenzteilers. Die zuletzt genannten Merkmale sowie die Verwendung einer Kaskade aus Differenzverstärkern ist in Figur 2 gezeigt.

Die Erfindung wird nun anhand der Figuren 1 und 2 näher beschrieben.

Bei der in Figur 1 dargestellten Ausführungsform der Erfindung liegt der von periodischen Impulsen der zu teilenden Frequenz beaufschlagte Signaleingang E über einen Kondensator C1 am Basisanschluß des ersten npn-Transistors T1 des Differenzverstärkers T1, T2, dessen Emitter mit dem Emitter eines gleichen Transistors T2 verbunden ist. Die Emitter beider Transistoren T1 und T2 sind über eine Stromquelle St1 mit dem Bezugspotential (Masse) verbunden, während ihre Kollektoren über je einen Lastwiderstand L1 bzw. L2 mit dem ersten Versorgungspotential +U1 der Schaltung verbunden ist. Der durch die Basis des Transistors T2 gegebene Referenzeingang des Differenzverstärkers T1, T2 ist über einen durch die beiden Widerstände $Rx, R^*$ gegebenen Spannungsteiler mit dem durch die Basis des ersten Transistors T1 gegebenen Signaleingang des Differenzverstärkers T1, T2 verbunden. An den Teilerpunkt ist das auf Masse bezogene Referenzpotential $U_{ref}$ gelegt.

Die Stromquelle St1 ist im Beispielsfall durch einen weiteren npn-Transistor gegeben, dessen Emitter unmittelbar am Bezugspotential (Masse), dessen Basis an einen dritten Betriebspotential $U_3$ und dessen Kollektor an den Emittern der beiden npn-Transistoren T1 und T2 des Differenzverstärkers liegt. Die Stromquelle St1 könnte z.B. auch durch einen Stromspiegel gegeben sein.

Die Ausgestaltung der Transistoren T1, T2 des Vorverstärkers als npn-Transistoren hat gegenüber der (ebenfalls möglichen) Verwendung von pnp-Bipolartransistoren
den Vorteil der größeren Schaltgeschwindigkeit. Die Schaltung kann aber auch unter Verwendung von MOS-Feldeffekttransistoren, insbesondere mit selbstsperrenden Transistoren vom n-Kanaltyp, realisiert werden. Im allgemeinen
wird sich die Auswahl der den Differenz-und den Operationsverstärker bildenden Transistoren nach den in den
Flip-Flopzellen FF1, FF2,.... des Frequenzteilers Te verwendeten Transistoren richten, um mit möglichst geringem
Aufwand eine monolithische Zusammenfassung der Schaltung
zu erreichen. In den beiden Figuren sind ausschließlich
npn-Bipolartransistoren verwendet, wobei in Figur 1 von
einer Detaillierten Ausgestaltung der Flip-Flopzellen
Abstand genommen wurde.

Die Stromausgangselektroden, d.h. also die Kollektoren
der beiden Transistoren T1 und T2 des Differenzverstärkers,
liegen über je einen Widerstand R bzw. R' an je einem der
beiden Eingänge des in üblicher Weise ausgestalteten Operationsverstärkers OP. Dabei ist dem Eingangstransistor
T1 der nichtinvertierte und dem Referenztransistor T2
der invertierte Eingang des Operationsverstärkers OP zugeordnet. Beide Eingänge sind außerdem entsprechend der
Definition der Erfindung durch einen Kondensator C3 miteinander verbunden. Beide Kollektoren liegen außerdem an
je einem der beiden Eingänge der ersten Teilerstufe FF1
des Frequenzteilers Te.

Im Beispielsfalle gemäß Figur 1 hat der Frequenzteiler Te
vier Stufen FF1 bis FF4, an deren Ausgängen die aufgrund
der Teilung erhaltenen Signale abnehmbar sind. Die durch
je eine Flip-Flopzelle gegebenen Teilerstufen FF1, FF2,..
können in jeder bekannten und für einen Dualzähler bzw.
Frequenzteiler geeigneten Weise, z.B. als JK-Flip-Flopzellen ausgestaltet sein.

Wesentlich für die Erfindung ist, daß der Ausgang des Operationsverstärkers OP mit dem Basisanschluß des Referenztransistors T2 (bzw. bei Verwendung von MOS-Transistoren mit dem Gate von T2) verbunden ist, während andererseits eine Verbindung zwischen der Steuerelektrode, also dem Basisanschluß, dieses Referenztransistors T2 und dem Bezugspotential (Masse) über einen Kondensator C2 besteht. Außerdem liegt der Referenzeingang des Differenzverstärkers T1, T2, wie bereits festgestellt, über einen Widerstand Rx am Referenzpotential $U_{ref}$ sowie an einem weiteren - zur Basis des Signaleingangstransistors T1 des Differenzverstärkers T1, T2.

Wird bei der in Fig. 1 dargestellten Ausführungsart einer Teilerschaltung gemäß der Erfindung statt eines einzigen Differenzverstärkers T1, T2 eine Kaskade mehrerer hintereinandergeschalteter Differenzverstärker vom Typ des Differenzverstärkers T1, T2 verwendet, so liegen die in Serie geschalteten Widerstände Rx, $R^{*}$ und das Referenzpotential $U_{ref}$ sowie der Ausgang des Operationsverstärkers OP an den Transistoren T1, T2 des ersten Differenzverstärkers und die Eingänge des Operationsverstärkers an den Kollektoren des letzten Differenzverstärkers der Kaskade, die zudem zur Steuerung der ersten Teilerstufe FF1 des Frequenzteilers Te dienen.

Bei der in Figur 2 dargestellten Ausführungsform besteht der Vorverstärker aus zwei Differenzverstärkern T1, T2 bzw. T3, T4, die in der angegebenen Weise geschaltet sind. Die Widerstände Rx und $R^{*}$ haben hier die Bezeichnung R2, R1. Der zweite Differenzverstärker T3, T4 besteht ebenfalls aus npn-Transistoren, die über ihre Emitter durch eine zweite gemeinsame Stromquelle St2 an das Bezugspotential gelegt sind während ihre den Signalausgang des Vorverstärkers bildenden Kollektoren zusätzlich über je einen Lastwiderstand L3, L4 am ersten Versorgungspotential U1 liegen. Der Transistor T3 wird durch den Sig-

naleingangstransistor T1 und der Transistor T4 durch den Referenztransistor T2 der ersten Differenzstufe T1, T2 gesteuert. Der Kollektor des Transistors T3 steuert die Basis eines ersten , in Kollektorschaltung betriebenen Transistors T5 und der Kollektor des Transistors T4 einen zweiten, ebenfalls in Kollektorschaltung betriebenen Transistors T6, die ebenfalls beide vom npn-Typ sind. Falls der Vorverstärker lediglich aus dem Differenzverstärker T1, T2 besteht, so wird die Basis des Transistors T5 durch den Eingangstransistor T1 und die Basis des Transistors T6 unmittelbar durch den Referenztransistor T2 des ersten Differenzverstärkers T1, T2 gesteuert.

Die Emitter der beiden Transistoren T5 und T6 liegen einerseits an je einem Signaleingang der ersten Teilerstufe sowie über je einem Widerstand R4 bzw. R5 am Bezugspotential der Schaltung. Schließlich sind die Emitter der aufgrund der beschriebenen Schaltung als Emitterfolger arbeitenden Transistoren T5 und T6 mit je einem der beiden Eingänge des Operationsverstärkers OP verbunden, wobei im gezeichneten Beispielsfall der durch den Transistor T2 bzw. T4 gesteuerte npn-Transistor T5 über einen Widerstand R3 an den invertierenden Eingang und der durch den Transistor T1 bzw. T3 gesteuerte Transistor T6 an den direkten Eingang des Operationsverstärkers OP angeschaltet ist.

Der Teiler Te besteht ebenfalls aus npn-Transistoren. Im Beispielsfall ist nur eine Teilerstufe dargestellt.

Bei dieser ist der durch den Transistor T5 beaufschlagte Eingang durch die Basisanschlüsse zweier Transistoren t6, t7 gegeben, die zusammen mit jeweils einem weiteren Transistor t5 bzw. t3 je einen Differenzverstärker t5, t6 bzw. t7, t3 bilden. Dem Differenzverstärker t5, t6 ist eine Konstantstromquelle St3 und dem Differenzverstärker t7, t3 eine Konstantstromquelle St4 zugeordnet. Beide

Differenzverstärker t5, t6 bzw. t7,t8 dienen zur Steuerung jeweils zweier weiterer Transistorpaare t1,t2 und t3,t4 bzw. t9, t10 und t11, t12, deren Transistoren - im Gegensatz zu den Transistoren der Differenzverstärker - ausschließlich über ihre Kollektoren zusammengefaßt und über je einen Lastwiderstand L5 bis L8 an das erste Versorgungspotential U1 angeschlossen sind. Die Basisanschlüsse der einzelnen Transistoren t1 bis t4 sind mit den Basisanschlüssen der Transistoren t9 bis t12 in der aus der Fig. 2 ersichtlichen und an sich bekannten Weise verbunden. Außerdem werden diese Transistorpaare über die Emitter ihrer Transistoren in der ebenfalls aus Figur 2 ersichtlichen Weise gesteuert. Da es sich bei der gezeichneten Ausgestaltung der Teilerstufe FF1 um den Stand der Technik handelt, kann auf die weitere Darstellung von Details verzichtet werden. Die Ausgänge der Teilerstufe in Fig.2 bzw. des Teilers Te in Fig. 1 sind mit A1, A2 bzw. A bezeichnet.

Hinsichtlich der Wirkung der erfindungsgemäßen Maßnahmen ist folgendes festzustellen:

Die aus den Widerständen R,R' bzw. R4, R6 und dem Kondensator C3 gegebene Schaltungskombination bildet einen Tiefpaß. Durch diesen wird das hochfrequente Signal abgetrennt, während die Gleichspannungskomponente den Operationsverstärker OP ansteuert. Der Gegentakt-Stromausgang des Operationsverstärkers OP kompensiert an der Basis des Referenztransistors im Differenzverstärker T1,T2 über den Lastwiderstand $R^*$ bzw. R1, R2 den Offset an den Eingängen und damit den Transistoren der ersten Teilerstufe FF1 des Teilers Te, und zwar bis zu einer - entsprechend der Regelverstärkung - verbleibenden Restabweichung. Der den Ausgang des Operationsverstärkers OP mit dem Bezugspotential (Masse) verbindende Kondensator C2 hat dabei folgende Funktion:

1.) Abblockung der Referenz, damit der HF-Vorverstärker T1, T2 bzw. T1, T2, T3, T4 die maximale Verstärkerwirkung erhält und

2.) Wirkung als Tiefpaßglied im Regelkreis der Arbeitspunkt-Gegenkopplung zur Unterdrückung von Regelschwingungen.

2 Figuren

6 Patentansprüche

0077500

P a t e n t a n s p r ü c h e

1.) Integrierbare Frequenzteilerschaltung, bei der das zu verarbeitende Eingangsignal über einen Vorverstärker an die zu beaufschlagenden Signaleingänge der ersten Teilerstufe des aus einer Anzahl hintereinandergeschalteter, gleicher Flip-Flopzellen bestehenden Frequenzteilers gelangt, dadurch gekennzeichnet, daß der als Differenzverstärker (T1, T2 bzw. T1 - T4) ausgebildete Vorverstärker mit seinen beiden Ausgängen zur Steuerung je eines Eingangs der ersten Teilerstufe (FF1) des Frequenzteilers (Te) vorgesehen und außerdem zur Steuerung je eines der beiden Eingänge eines Operationsverstärkers (OP) unter Vermittlung je eines Widerstands (R,R' bzw. R3, R5) vorgesehen ist, daß dabei die beiden Eingänge des Operationsverstärkers (OP) über einen Kondensator (C3) miteinander verbunden sind und daß außerdem der Ausgang des Operationsverstärkers (OP) kapazitiv (C2) an das Bezugspotential gelegt und andererseits unmittelbar mit dem Referenzeingang (T2) des Differenzverstärkers (T1, T2) verbunden ist.

2.) Frequenzteilerschaltung nach Anspruch 1, dadurch gekennzeichnet, daß das Eingangssignal an den Differenzverstärker (T1, T2) über einen Kondensator (C1) gelangt.

3.) Frequenzteilerschaltung nach Anspruch 1 oder 2, dadurch gekennzeichnet, daß der Signaleingang (T1) des Differenzverstärkers (T1, T2) mit dem Referenzeingang (T2) dieses Differenzverstärkers (T1, T2) über wenigstens einen Widerstand (Rx,R$^{*}$ bzw. R1, R2) verbunden ist.

4.) Frequenzteilerschaltung nach Anspruch 3, dadurch gekennzeichnet, daß der Signaleingang (T1) des Differenzverstärkers (T1, T2) mit dem Referenzeingang (T2) über die Reihenschaltung zweier Widerstände (Rx, R$^*$ bzw. R1, R2) verbunden ist, deren Teilerpunkt das für die Beaufschlagung des Referenzeingangs (T2) des Differenzverstärkers (T1, T2) vorgesehene Referenzpotential ($U_{ref}$) führt.

5.) Frequenzteilerschaltung nach einem der Ansprüche 1 bis 4, dadurch gekennzeichnet, daß der Differenzverstärker (T1, T2) zwecks Beaufschlagung des Operationsverstärkers und des Frequenzteilers (Te) an die Eingänge einer die Steuerung dieser Schaltungsteile vermittelnden weiteren Differenzverstärkerstufe (T3, T4) gelegt ist.

6.) Frequenzteilerschaltung nach einem der Ansprüche 1 bis 5, dadurch gekennzeichnet, daß zwischen den Ausgangsanschlüssen des Differenzverstärkers (T1, T2) bzw. einer diesem nachgeschalteten weiteren Differenzverstärkerstufe (T3, T4) und je einem der beiden Eingänge des Operationsverstärkers (OP) je ein in Emitterfolgerschaltung betriebener Transistor (T5, T6) geschaltet ist, dessen Emitter einerseits zur Beaufschlagung je eines Eingangs der ersten Teilerstufe und andererseits zur Beaufschlagung je eines der beiden Eingänge des Operationsverstärkers (OP) dient, wobei die beiden Eingänge des Operationsverstärkers (OP) unter Vermittlung je eines Widerstands (R3, R5) an den Emitter des jeweils zugeordneten Transistors (T5, T6) gelegt sind.

FIG 1

FIG 2